# EUROPÄISCHE PATENTSCHRIFT

(11) **EP 1 774 596 B1**
(45) Veröffentlichungstag und Bekanntmachung des Hinweises auf die Patenterteilung: **09.01.2008**
(21) Anmeldenummer: 05768556.2
(22) Anmeldetag: 05.08.2005
(51) Int. Cl.: H01L 29/78, H01L 29/10, H01L 29/08, H01L 29/06, H01L 21/336

(54) **HOCHVOLT-NMOS-TRANSISTOR UND HERSTELLUNGSVERFAHREN**
HIGH-VOLTAGE NMOS-TRANSISTOR AND ASSOCIATED PRODUCTION METHOD
TRANSISTOR NMOS HAUTE TENSION ET PROCEDE DE PRODUCTION ASSOCIE

(30) Priorität: 06.08.2004 DE 102004038369
(43) Veröffentlichungstag der Anmeldung: 18.04.2007
(73) Patentinhaber: austriamicrosystems AG, 8141 Unterpremstätten (AT)
(72) Erfinder: KNAIPP, Martin, A-8141 Unterpremstätten (AT); PARK, Jong Mun, A-8010 Graz (AT)
(74) Vertreter: Epping, Wilhelm
(86) Internationale Anmeldenummer: PCT/EP2005/008542
(87) Internationale Veröffentlichungsnummer: WO 2006/015822

(56) Entgegenhaltungen:
- DE-A1- 19 702 102
- US-A- 4 587 713
- US-A1- 2001 031 533

## Beschreibung

Die Erfindung betrifft einen lateralen Hochvolt-NMOS-Transistor mit einer p-leitenden Wanne, die in einer n-leitenden Wanne angeordnet ist, einem Kanalbereich, einer von dem Kanalbereich isolierten Gate-Elektrode mit Gate-Feldplatte, einem n-leitenden Source-Bereich in der p-leitenden Wanne und einem n-leitenden Drain-Bereich in der n-leitenden Wanne.

Ein lateraler Hochvolt-NMOS-Transistor, bei dem Source, Kanal und Drain nebeneinander an der Oberseite eines p-Substrates angeordnet sind, ist zum Beispiel aus der US 6 455 893 B1 bekannt. Ein drainseitiger Rand der Gate-Elektrode ist auf einer Feldplatte angeordnet. Die Bereiche von Source und Drain sind n-leitend, und der Drain-Bereich ist in einem ebenfalls n-leitenden Drain-Erweiterungsbereich angeordnet, der sich bis zu einer Driftstrecke fortsetzt, die anschließend an den Kanalbereich unter der Feldplatte verläuft.

In der Veröffentlichung von R. Zhu et al.: "Implementation of High-Side, High-Voltage RESURF LDMOS in a sub-half Micron Smart Power Technology" in Proceedings of 2001 International Symposium on Power Semiconductor Devices & ICs, Osaka, pp. 403 - 406, ist ein Hochvolt-NMOS-Transistor beschrieben, bei dem ein p-Body-Bereich mit einem darin angeordneten n⁺-Source-Bereich und eine n-Wanne mit einem darin angeordneten n+-Drain-Bereich vorhanden sind. Der p-Body-Bereich kann in der n-Wanne angeordnet sein oder bei einer demgegenüber neuen Ausgestaltung in weiteren p-leitenden Bereichen. Ein p-leitender Kanalbereich wird mit einer Gate-Elektrode gesteuert, die teils auf ein zwischen dem Drain-Bereich und dem Kanalbereich angeordnetes Feldoxid gezogen ist.

In der Veröffentlichung von H. Lu und C. A. T. Salama: "A 2GHz, 60V-Class, SOI Power LDMOSFET for Base Station Applications" in International Symposium on Power Semiconductor Devices (ISPSD) 2003, Seiten 270 - 273, ist ein LDD-Extension-Hochvolt-Bauelement beschrieben, bei dem kein Feldoxid zwischen dem Drain-Bereich und dem Kanalbereich vorhanden ist, sondern ein LDD-Bereich (lightly doped drain), der n'-dotiert ist und sich an den n⁺-dotierten Drain-Bereich anschließt. Dieses Bauelement ist für Hochfrequenzanwendungen vorgesehen.

In der DE 197 02 102 A1 ist ein Hochvolt-NMOS-Transistor beschrieben, bei dem in einem schwach p-leitend dotierten Substrat eine tiefe n-leitend dotierte Wanne und darin eine p-leitend dotierte Wanne ausgebildet sind, ein n-leitend dotierter Source-Bereich, ein n-leitend dotierter Drain-Bereich und ein Kanalbereich angrenzend an den Source-Bereich sowie eine von dem Kanalbereich elektrisch isolierte, über dem Kanalbereich angeordnete Gate-Elektrode vorhanden sind und zwischen dem Kanalbereich und dem Drain-Bereich eine Driftstrecke vorhanden ist. Ein Anteil der Driftstrecke ist durch eine n-leitende Schicht auf der p-leitend dotierten Wanne gebildet, die dadurch hergestellt wird, dass die p-leitende Oberseite des Substrates thermisch oxidiert wird. Dabei wird ausgenutzt, dass dort ungleichförmig verteilte Phosphorionen und aufgelöste beziehungsweise im Gitter verteilte Borionen vorhanden sind, die durch die Oxidation gleichmäßig verteilt werden.

In der DE 199 29 235 A1 ist ein vertikaler DMOS-Transistor beschrieben, der durch Isoliergebiete von angrenzenden Bauelementen isoliert ist.

In der DE 43 09 764 A1 ist ein Leistungs-MOSFET beschrieben, bei dem im Bereich der Raumladungszone höher dotierte Bereiche eines der übrigen Innenzone entgegengesetzten Leitungstyps angeordnet sind. Dazwischen liegen Zonen, die den Leitungstyp der Innenzone, aber höhere Dotierung haben.

In der DE 100 61 528 C1 und der DE 101 20 030 A1 sind Hochvolt-NMOS-Transistoren beschrieben, bei denen von einer tiefen p-leitend dotierten Wanne getrennte p-Streifen in der Driftzone vorhanden sind.

In der US 5 347 155 ist ein Leistungshalbleiterbauelement beschrieben, das einen rahmenförmigen Drain-Bereich aufweist.

In der US 6 100 572 ist ein Leistungs-MOSFET beschrieben, der eine flache p-leitend dotierte Wanne aufweist, in die der Source-Bereich ragt.

Es ist oftmals erwünscht, einen Hochvolt-NMOS-Transistor anstelle eines Hochvolt-PMOS-Transistors einzusetzen. Bei den Hochvolt-NMOS-Transistoren besteht jedoch ebenso das Problem, dass die Betriebseigenschaften und die elektrischen Eigenschaften, insbesondere der ohmsche Widerstand im eingeschalteten Zustand, die Widerstandsfähigkeit gegen das so genannte Latch-up und das Auftreten eines Source-Drain-Durchbruches, nicht gleichzeitig optimiert werden können. Es muss daher ein gewisser Kompromiss zwischen diesen Eigenschaften eingegangen werden.

Aufgabe der vorliegenden Erfindung ist es, einen Hochvolt-NMOS-Transistor der eingangs beschriebenen Art anzugeben, der eine höhere Source-Drain-Breakdown-Spannung besitzt, zugleich aber verbesserte Latch-up-Eigenschaften aufweist und vorteilhaft hergestellt werden kann. Es soll auch ein geeignetes Herstellungsverfahren angegeben werden.

Diese Aufgabe wird mit dem Hochvolt-NMOS-Transistor mit den Merkmalen des Anspruches 1 beziehungsweise mit dem Herstellungsverfahren mit den Merkmalen des Anspruches 3 gelöst. Ausgestaltungen der Erfindung sind in weiteren Ansprüchen gekennzeichnen.

Ein Hochvolt-NMOS-Transistor gemäß dem Oberbegriff des Anspruchs 1 ist aus der US-A-2001/0031533 bekannt.

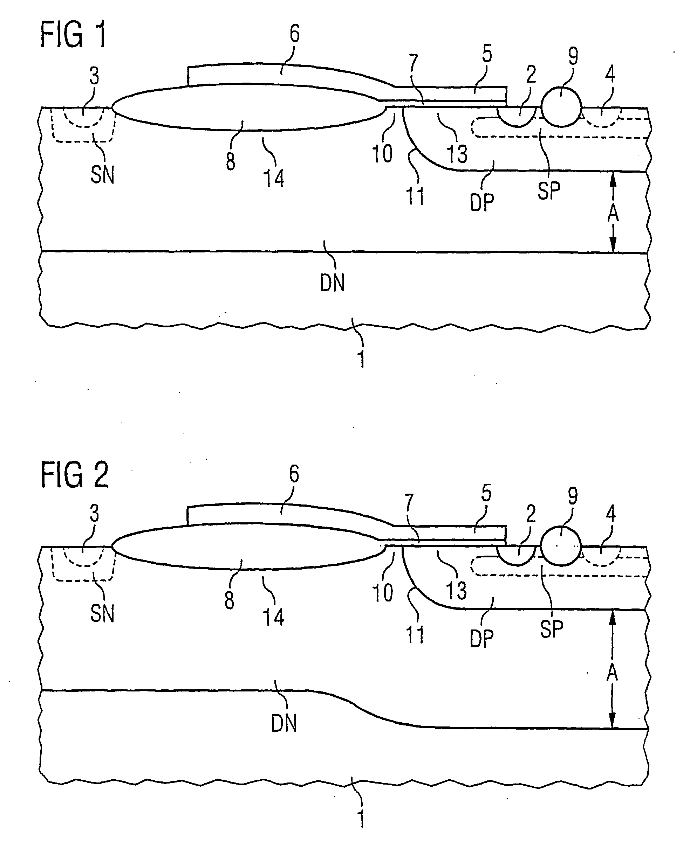

Zur näheren Erläuterung der Funktionsweise des Hochvolt-NMOS-Transistors sowie des erfindungsgemäß gelösten Problems wird im Folgenden zunächst ein Hochvolt-NMOS-Transistor gemäß einer im Prinzip vorteilhaften Struktur anhand der beigefügten Figuren 1 und 2 beschrieben.

Die Figur 1 zeigt einen Ausschnitt aus einem Querschnitt durch einen Hochvolt-NMOS-Transistor. Bei diesem Bauelement ist an einer Oberseite eines Halbleiterkörpers oder Substrates 1 eine tiefe n-leitend dotierte Wanne DN ausgebildet. Innerhalb der tiefen n-leitend dotierten Wanne DN ist eine tiefe p-leitend dotierte Wanne DP angeordnet, die aber nur eine geringere Tiefe als die tiefe n-leitend dotierte Wanne DN erreicht. Zwischen einer im Wesentlichen ebenen unteren Begrenzungsfläche der tiefen n-leitend dotierten Wanne DN und einer ebenfalls im Wesentlichen ebenen unteren Grenz- oder Übergangsfläche zwischen der tiefen p-leitend dotierten Wanne DP und der tiefen n-leitend dotierten Wanne DN befindet sich der in der Figur 1 markierte Abstand A, der nicht zu groß und nicht zu klein sein darf, um geeignete Betriebseigenschaften des Bauelementes sicherzustellen.

Wenn der Abstand A zu klein gewählt wird, kommt es insbesondere bei einem mit einer p-Grunddotierung versehenen Substrat 1 zu dem so genannten Latch-up, bei dem der durch die dotierten Bereiche gebildete vertikale pnp-Transistor durchschaltet. Eine Beeinträchtigung der Funktionsweise des Hochvolt-NMOS-Transistors ist die Folge. Ein großer Abstand A verbessert außerdem den Widerstand des Transistors in eingeschaltetem Zustand. Um die Funktionsweise des Transistors in dem für die Betriebsspannungen vorgesehenen Bereich sicherzustellen, darf der Abstand A dagegen nicht zu groß werden. Die Tiefen der tiefen n-leitend dotierten Wanne DN und der tiefen p-leitend dotierten Wanne DP sind andererseits durch weitere Randbedingungen des Herstellungsprozesses bedingt. Insbesondere, falls mit dem Bauelement Hochvolt-PMOS-Transistoren integriert werden sollen und die Anzahl der Verfahrensschritte nicht oder nicht wesentlich erhöht werden darf, sind die Tiefen der besagten Wannen und deren Dotierungsprofile im Wesentlichen vorgegeben.

Im Fall einer besonders tiefen p-leitend dotierten Wanne DP ist der als Junction 11 bezeichnete pn-Übergang zwischen den Wannen an der Seite relativ steil und besitzt eine große vertikale Ausdehnung. Das ist für die Funktionsweise des Hochvolt-NMOS-Transistors von Nachteil.

Im Weiteren sollen zunächst die übrigen Elemente des Transistors angegeben werden. In der tiefen p-leitenden Wanne DP ist an der Oberseite ein n-leitend dotierter Source-Bereich 2 angeordnet. Innerhalb der tiefen p-leitend dotierten Wanne DP ist vorzugsweise eine flache p-leitend dotierte Wanne SP angeordnet, die schichtartig ausgebildet und höher dotiert ist als die tiefe p-leitend dotierte Wanne DP. Der Source-Bereich 2 taucht ein Stück weit in diese flache p-leitend dotierte Wanne SP ein. Die flache p-leitend dotierte Wanne SP kann mit einem p⁺-leitend dotierten Body-Bereich 4 versehen sein, der für einen externen Anschluss (Masse) der p-Wannen vorgesehen ist. Zwischen dem Source-Bereich 2 und dem Body-Bereich 4 ist bei dem dargestellten Beispiel zur Isolation ein Feldoxid 9 aus dem Oxid des betreffenden Halbleitermaterials, vorzugsweise Siliziumdioxid, vorhanden.

Angrenzend an den Source-Bereich 2 befindet sich der Kanalbereich 13 an der Oberseite des Substrates 1 innerhalb der tiefen p-leitend dotierten Wanne DP. Oberseitig befindet sich ein dünnes Gate-Dielektrikum 7, auf dem die Gate-Elektrode 5 angeordnet ist. Zur besseren Einstellung des elektrischen Feldes, insbesondere zur Reduktion der elektrischen Feldstärke an der Oberseite in einem als Driftstrecke 14 für die Ladungsträger vorgesehenen Bereich befindet sich an der Oberseite des Substrates ein Gate-Feldoxid 8, auf dem eine mit der Gate-Elektrode 5 elektrisch leitend verbundene Gate-Feldplatte 6 angeordnet ist.

In der Figur 1 ist um den Drain-Bereich 3 herum eine flache n-leitend dotierte Wanne SN dargestellt, die niedriger dotiert ist als der Drain-Bereich 3 und höher dotiert als die tiefe n-leitend dotierte Wanne DN. Mit einer solchen flachen n-leitend dotierten Wanne SN lässt sich ein weniger abrupter Übergang zwischen der hohen n-Dotierung des Drain-Bereiches 3 und der niedrigeren n-Dotierung der tiefen n-leitend dotierten Wanne bewirken.

Bei diesem Transistor tritt das Problem auf, dass an der hohen und steilen lateralen Junction 11 am Kanalende im Betrieb des Transistors eine hohe elektrische Feldstärke auftritt. An dieser Stelle ist daher ein kritischer Breakdown-Bereich 10 vorhanden, in dem bei Anliegen einer elektrischen Spannung in Sperrrichtung zwischen Source und Drain ein starker Spannungsabfall auftritt, der die Einsatzspannung des Transistors reduzieren oder sogar zum Auftreten eines kurzschlussartigen Stromes und zur Zerstörung des Transistors führen kann.

In der Figur 2 ist ein der Figur 1 entsprechender Querschnitt durch eine alternative Ausführungsform eines derartigen Hochvolt-NMOS-Transistors dargestellt, bei der im Unterschied zu der Ausführungsform gemäß der Figur 1 der Abstand A dadurch vergrößert ist, dass die untere Begrenzungsfläche der tiefen n-leitend dotierten Wanne DN unterhalb der tiefen p-leitend dotierten Wanne DP tiefer liegt. Damit ist zwar dieser Teil des Transistors optimiert; der Breakdown-Bereich 10 am Ende des Kanals ist jedoch auch hier vorhanden.

Bei dem erfindungsgemäßen Hochvolt-NMOS-Transistor ist die steile drainseitige Grenzfläche zwischen der tiefen n-leitend dotierten Wanne und der tiefen p-leitend dotierten Wanne in den Bereich der Driftstrecke, insbesondere in den Bereich unterhalb des Gate-Feldoxids, verschoben. Damit wird erreicht, dass im Betrieb des Transistors ein höherer Spannungsabfall in der Nähe des Drain-Bereiches auftritt. Der Spannungsabfall wird so über die gesamte Source-Drain-Strecke gleichmäßiger verteilt, was die Breakdown-Spannung erhöht. Die tiefe p-leitend dotierte Wanne kann auch in zwei getrennten Anteilen vorhanden sein. Ein sourceseitiger Anteil der tiefen p-leitend dotierten Wanne entspricht etwa der in der Figur 1 dargestellten tiefen p-leitend dotierten Wanne DP. Ein drainseitiger Anteil befindet sich in einem Abstand zu dem sourceseitigen Anteil im Bereich der Driftstrecke, insbesondere unterhalb des Gate-Feldoxids. Die Driftstrecke umfasst einen Gegendotierungsbereich in der tiefen p-leitend dotierten Wanne, gegebenenfalls zusätzlich zu einem zwischen Anteilen der tiefen p-leitend dotierten Wanne vorhandenen Strompfad, der sich unterhalb eines drainseitigen Anteils dieser Wanne fortsetzt. Bei der letztgenannten Ausführungsform ist der Gegendotierungsbereich für die Driftstrecke in dem drainseitigen Anteil der tiefen p-leitend dotierten Wanne vorhanden. Der Gegendotierungsbereich wird zur Verringerung der p-Leitfähigkeit und zur Erzielung eines ausreichend hohen Ladungsträgerflusses unterhalb des Gate-Feldoxids zumindest im oberen Bereich der tiefen p-leitend dotierten Wanne DP durch Einbringen von Dotierstoff für n-Leitung ausgebildet, so dass sich dort insgesamt eine ausreichende Leitfähigkeit für Elektronen ergibt. Die Implantation von Dotierstoff zur Ausbildung des Gegendotierungsbereiches erfolgt vorzugsweise nach dem Herstellen des Gate-Feldoxids.

Eine Ausführungsform mit einem Gate-Feldoxid ist bevorzugt, das Gate-Feldoxid und die Gate-Feldplatte können jedoch grundsätzlich auch nach Art eines an sich bekannten LDD(lightly doped drain)-Extension-Bauelementes weggelassen sein, bei dem die Driftstrecke nicht von einem mit der Gate-Elektrode verbundenen Leiter überdeckt wird.

Es folgt eine genauere Beschreibung von Beispielen des Hochvolt-NMOS-Transistors anhand der beigefügten Figuren.
Die Figur 1 zeigt einen Querschnitt eines Hochvolt-NMOS-Transistors mit Breakdown-Bereich im Kanal.
Die Figur 2 zeigt ein weiteres Ausführungsbeispiel des Transistors gemäß der Figur 1 im Querschnitt.
Die Figur 3 zeigt einen Querschnitt eines ersten Ausführungsbeispiels eines erfindungsgemäßen Hochvolt-NMOS-Transistors.
Die Figur 4 zeigt einen Querschnitt entsprechend der Figur 3 durch ein weiteres Ausführungsbeispiel des erfindungsgemäßen Hochvolt-NMOS-Transistor.
Die Figur 5 zeigt einen Querschnitt gemäß der Figur 3 für ein Ausführungsbeispiel ohne Gate-Feldplatte.
Die Figur 6 zeigt einen Querschnitt gemäß der Figur 4 für ein Ausführungsbeispiel ohne Gate-Feldplatte.

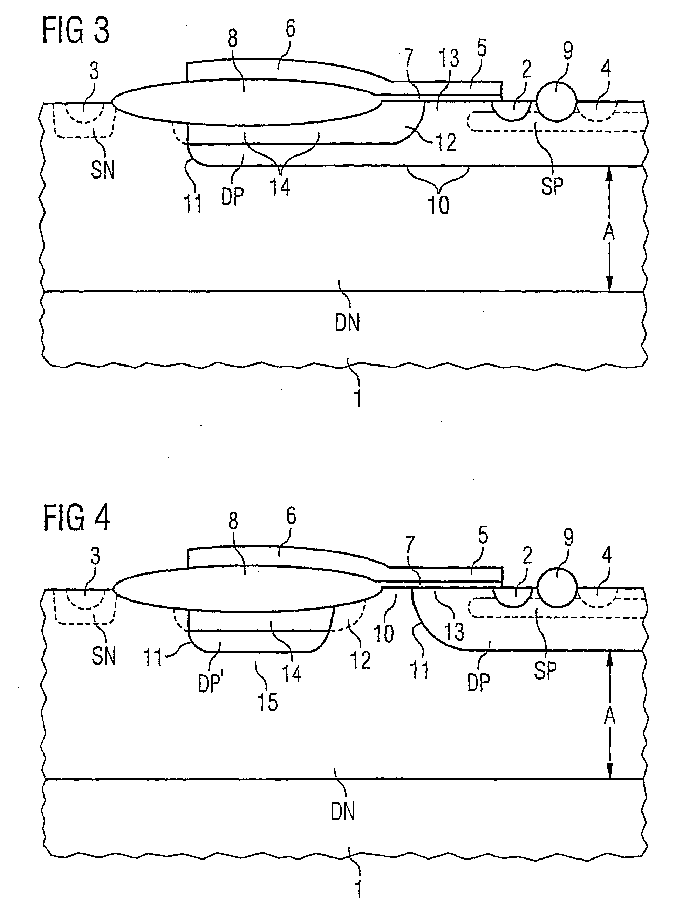

Die Figur 3 zeigt einen Querschnitt entsprechend dem Querschnitt der Figur 1 für ein erstes Ausführungsbeispiel des erfindungsgemäßen Hochvolt-NMOS-Transistors. Die eingetragenen Bezugszeichen bezeichnen die entsprechenden Elemente, die bereits anhand der Figur 1 beschrieben worden sind. Sie werden daher nur der Vollständigkeit halber nochmals angegeben. In einem Halbleiterkörper oder Substrat 1 sind oberseitig eine tiefe n-leitend dotierte Wanne DN und darin eine tiefe p-leitend dotierte Wanne DP ausgebildet, deren untere Begrenzungsflächen einen Abstand A voneinander aufweisen. In der tiefen p-leitend dotierten Wanne DP befindet sich bei diesem Ausführungsbeispiel vorzugsweise eine flache höher p-leitend dotierte Wanne SP, in und über welcher der n-leitend dotierte Source-Bereich 2 angeordnet ist. Zum Anschluss der flachen p-leitend dotierten Wanne SP kann ein hoch p-leitend dotierter Body-Bereich 4 vorgesehen sein. Zwischen dem Source-Bereich 2 und dem Body-Bereich 4 befindet sich vorzugsweise ein Isolationsbereich, hier ein Feldoxid 9. Der Drain-Bereich 3 ist n-leitend dotiert und vorzugsweise in einer flachen n-leitend dotierten Wanne SN an der Oberseite angeordnet. Die Dotierstoffkonzentration der flachen n-leitend dotierten Wanne liegt zwischen der höheren Dotierstoffkonzenzentration des Drain-Bereiches 3 und der niedrigeren Dotierstoffkonzentration der tiefen n-leitend dotierten Wanne DN. Zwischen Source und Drain befindet sich der Kanalbereich 13 und darüber die Gate-Elektrode 5, die elektrisch durch das Gate-Dielektrikum 7 von dem Halbleitermaterial isoliert und gegebenenfalls mit einer Gate-Feldplatte 6 auf dem Gate-Feldoxid 8 elektrisch leitend verbunden ist. Das Gate-Feldoxid 8 wird im Hinblick darauf, dass die flache n-leitend dotierte Wanne SN vorzugsweise durch das Gate-Feldoxid 8 hindurch implantiert wird, höchstens 0,5 µm dick ausgebildet und nach der Herstellung der tiefen n-leitend dotierten Wanne DN und der tiefen p-leitend dotierten Wanne DP und vor der Herstellung der flachen n-leitend dotierten Wanne SN zum Beispiel mittels thermischer Oxidation des Halbleitermateriales hergestellt. Die tiefe n-leitend dotierte Wanne DN wird unter Verwendung einer ersten Maske, hier als DN-Maske bezeichnet, die tiefe p-leitend dotierte Wanne DP unter Verwendung einer zweiten Maske, hier als DP-Maske bezeichnet, und die flache n-leitend dotierte Wanne SN unter Verwendung einer dritten Maske, hier als SN-Maske bezeichnet, durch Implantationen von Dotierstoff hergestellt. Zur Implantation der flachen p-leitend dotierten Wanne SP wird entsprechend eine vierte Maske, hier als SP-Maske bezeichnet, verwendet. Die Masken sind in an sich bekannter Weise jeweils entsprechend den herzustellenden Bereichen strukturiert.

Ein Unterschied zu dem Transistor der eingangs beschriebenen Art besteht darin, dass die tiefe p-leitend dotierte Wanne DP so weit in die Driftstrecke 14 unter das Gate-Feldoxid 8 gezogen ist, dass der vertikale Anteil der Junction 11 in der Nähe des Drain-Bereiches 3 angeordnet ist. Ein Donatorgebiet in der Driftstrecke 14 unter dem Gate-Feldoxid 8, das für die Ableitung von Elektronen zum Drain hin geeignet ist, wird durch einen Gegendotierungsbereich 12 gebildet, in den für n-Leitfähigkeit vorgesehene Dotierstoffatome (Donatoren) eingebracht sind. Deren Konzentration ist so gewählt, dass sich in dem Bereich, in dem der Gegendotierungsbereich 12 mit der tiefen p-leitend dotierten Wanne DP überlappt, insgesamt eine ausreichende n-Leitfähigkeit einstellt und dort Elektronen von Source nach Drain fließen können. Bei der finalen Ausbildung der Dotierbereiche übersteigen vorzugsweise die zur Verfügung stehenden Akzeptoren der tiefen p-leitend dotierten Wanne DP die zur Verfügung stehenden Donatoren der flachen n-leitend dotierten Wanne SN. Dadurch ergibt sich eine Netto-Akzeptorenkonzentration, die die Feldstärke im Breakdown-Bereich (10) reduziert. Der Potenzialabfall zwischen Source und Drain ist damit zum Drain hin verschoben.

In den Figuren sind jeweils Grenzen zwischen n-leitendem Bereich und p-leitendem Bereich durchgezogen, während die Begrenzungen zwischen Bereichen gleichen Leitfähigkeitstyps, aber unterschiedlicher Dotierstoffkonzentration, gestrichelt eingezeichnet sind. Dementsprechend ist der in der Figur 3 dargestellte Gegendotierungsbereich 12 außerhalb der tiefen p-leitend dotierten Wanne DP mit gestrichelter Kontur eingezeichnet.

Der Breakdown-Bereich 10 ist bei dieser Ausführungsform die unter dem Kanalbereich 13 vorhandene Grenzfläche zwischen der tiefen p-leitend dotierten Wanne DP und der tiefen n-leitend dotierten Wanne DN. Eine hohe Feldstärke in dem kritischen Bereich am Ende des Kanalbereiches 13 ist auf diese Weise vermieden und die Breakdown-Spannung zwischen Source und Drain deutlich erhöht. Das elektrische Feld ist gleichmäßiger über den gesamten Bereich zwischen Source und Drain verteilt, und insbesondere ist in dem unter dem Gate-Feldoxid 8 vorhandenen Driftbereich 14 der Ladungsträger eine ausreichend geringe Feldstärke vorhanden. Der Abstand A zwischen den unteren Grenzflächen der tiefen p-leitend dotierten Wanne und der tiefen n-leitend dotierten Wanne kann maximiert werden. Auf diese Weise sind bei dem Transistor verschiedene Betriebseigenschaften gleichzeitig optimiert.

Die Figur 4 zeigt ein alternatives Ausführungsbeispiel im Querschnitt, bei dem die tiefe p-leitend dotierte Wanne DP am Ende des Kanalbereiches 13 unterbrochen ist. Es befindet sich unter dem Gate-Feldoxid 8 ein drainseitiger Anteil (DP') der tiefen p-leitend dotierten Wanne, so dass bei diesem Ausführungsbeispiel zwei vertikale Junctions 11 der Grenzflächen der p-leitend dotierten Wanne auf der Seite zu dem Drain-Bereich hin vorhanden sind. Da aber bereits ein wesentlicher Spannungsabfall an der in der Figur 4 links eingezeichneten Junction auftritt, die dem Drain-Bereich näher ist, kommt es nicht mehr zu einer zu hohen Spannung im Breakdown-Bereich 10 am Kanalende. Auch bei dieser Ausführungsform ist daher die Breakdown-Spannung deutlich größer als bei herkömmlichen Hochvolt-NMOS-Transistoren. Zur Ausbildung der Driftstrecke 14 ist auch bei diesem Ausführungsbeispiel ein Gegendotierungsbereich 12 vorhanden. Der Gegendotierungsbereich 12 ist hier für den drainseitigen Anteil DP' der tiefen p-leitend dotierten Wanne vorgesehen. Bei eingeschaltetem Transistor fließen die Elektronen entlang der oberen, durch den Gegendotierungsbereich 12 gebildeten Driftstrecke 14 sowie entlang einer weiteren, durch die tiefe n-leitend dotierte Wanne DN unterhalb des drainseitigen Anteils DP' der p-leitend dotierten Wanne führenden Driftstrecke 15. Der Strom wird daher in zwei Stränge oder Strompfade aufgeteilt. Wie bei dem Ausführungsbeispiel der Figur 3 ist auch bei dem Ausführungsbeispiel der Figur 4 der Spannungsabfall im Breakdown-Bereich 10 durch den nahe dem Drain-Bereich 3 angeordneten vertikalen Anteil der Junction 11 so vermindert, dass sich eine für eine hohe Breakdown-Spannung zwischen Source und Drain ausreichend gleichmäßige Verteilung des elektrischen Feldes ergibt.

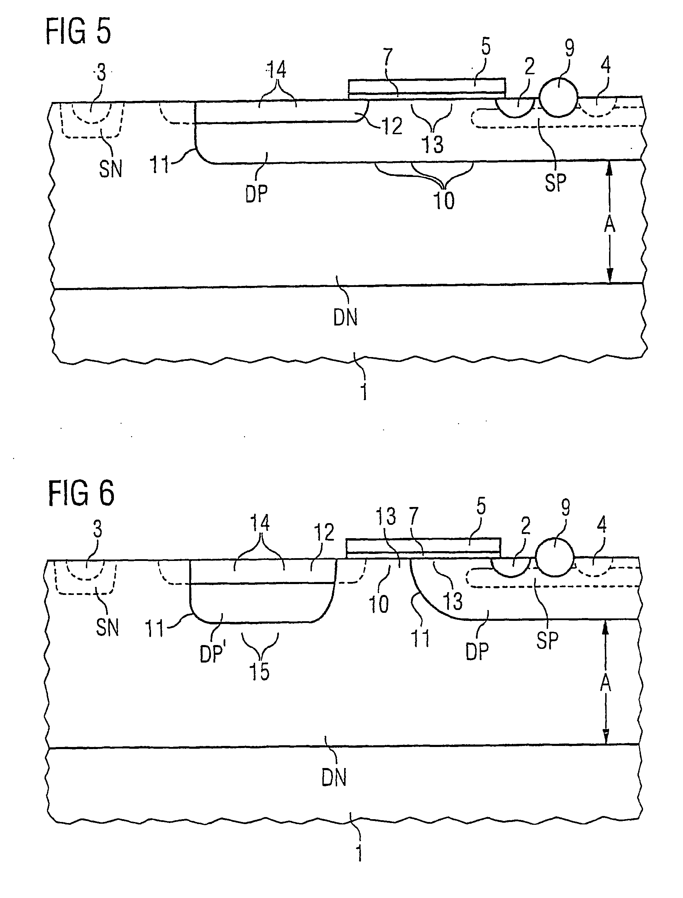

Die Ausführungsbeispiele, die in den Figuren 5 und 6 im Querschnitt dargestellt sind, entsprechen den Ausführungsbeispielen der Figuren 3 beziehungsweise 4 mit Ausnahme des Fehlens der Gate-Feldplatte und des Gate-Feldoxids. Die Halbleiteroberfläche ist hier oberhalb der Driftstrecke 14 planar. Die Ausführungsformen mit Gate-Feldoxid und Gate-Feldplatte sind bevorzugt; die in den Figuren 5 und 6 dargestellten Ausgestaltungen liegen aber im Rahmen der Erfindung.

Welche Ausführungsform des erfindungsgemäßen Hochvolt-NMOS-Transistors besonders bevorzugt ist, hängt auch von der Genauigkeit der eingesetzten Fototechnik ab. Bei den Ausführungsbeispielen gemäß den Figuren 3 bis 6 hängt die Leistungsfähigkeit des Transistors von der Positioniergenauigkeit, dem Overlay, zweier Masken für DP und SN ab. Je mehr Dopanden in das gleiche Volumen implantiert werden, umso größer ist der Fehler der mittleren Streuung.

### Bezugszeichenliste

- 1: Substrat
- 2: Source-Bereich
- 3: Drain-Bereich
- 4: Body-Bereich
- 5: Gate-Elektrode
- 6: Gate-Feldplatte
- 7: Gate-Dielektrikum
- 8: Gate-Feldoxid
- 9: Feldoxid
- 10: Breakdown-Bereich
- 11: Junction
- 12: Gegendotierungsbereich
- 13: Kanalbereich
- 14: Driftstrecke
- 15: Driftstrecke
- A: Abstand
- DN: tiefe n-leitend dotierte Wanne
- DP: tiefe p-leitend dotierte Wanne
- DP': drainseitiger Anteil der tiefen p-leitend dotierten Wanne
- SN: flache n-leitend dotierte Wanne
- SP: flache p-leitend dotierte Wanne

## Patentansprüche

1. Hochvolt-NMOS-Transistor, bei dem
in einem Halbleiterkörper oder Substrat (1) an einer Oberseite eine tiefe n-leitend dotierte Wanne (DN) und darin eine tiefe p-leitend dotierte Wanne (DP, DP') ausgebildet sind,
ein n-leitend dotierter Source-Bereich (2) in der tiefen p-leitend dotierten Wanne (DP) angeordnet ist,
ein Kanalbereich (13) angrenzend an den Source-Bereich (2) und eine von dem Kanalbereich elektrisch isolierte Gate-Elektrode (5) über dem Kanalbereich (13) vorhanden sind,
ein n-leitend dotierter Drain-Bereich (3) auf einer dem Source-Bereich (2) gegenüberliegenden Seite des Kanalbereiches (13) angeordnet ist,
zwischen dem Kanalbereich (13) und dem Drain-Bereich (3) eine Driftstrecke (14, 15) vorhanden ist,
ein Anteil der tiefen p-leitend dotierten Wanne (DP, DP') entlang der Driftstrecke (14, 15) vorhanden ist,
eine drainseitige Grenzfläche der tiefen p-leitend dotierten Wanne (DP, DP') im Bereich der Driftstrecke (14, 15) angeordnet ist, und
ein mit Donatoren dotierter Gegendotierungsbereich (12) vorhanden ist, der mit einem an der oberseite des Halbleiterkörpers oder Substrates (1) vorhandenen Bereich der tiefen p-leitend dotierten Wanne (DP, DP') überlappt und zumindest einen Anteil der Driftstrecke (14) bildet,
**dadurch gekennzeichnet, dass**
eine drainseitige Grenzfläche des Gegendotierungsbereiches (12) im Bereich der Driftstrecke (14, 15) angeordnet ist und der Drain-Bereich (3) sich in einer flachen n-leitend dotierten Wanne (SN) befindet, die in der tiefen n-leitend dotierten Wanne (DN) in einem Abstand getrennt von dem Gegendotierungsbereich (12) angeordnet ist.

2. Hochvolt-NMOS-Transistor nach Anspruch 1, bei dem
über der Driftstrecke (14, 15) ein Gate-Feldoxid (8) mit einer maximalen Dicke von 0,5 µm vorhanden ist.

3. Verfahren zur Herstellung eines Hochvolt-NMOS-Transistors, bei dem
in einem Halbleiterkörper oder Substrat (1) an einer Oberseite durch Implantationen von Dotierstoff eine tiefe n-leitend dotierte Wanne (DN), eine tiefe p-leitend dotierte Wanne (DP) und eine flache n-leitend dotierte Wanne (SN) hergestellt werden, wobei
die tiefe p-leitend dotierte Wanne (DP) in der tiefen n-leitend dotierten Wanne (DN) so angeordnet wird, dass sich eine in einem Abstand von der Oberseite vorhandene untere Grenzfläche der tiefen p-leitend dotierten Wanne (DP) in einem Abstand (A) über einer unteren Grenzfläche der tiefen n-leitend dotierten Wanne befindet, und ein Anteil der tiefen p-leitend dotierten Wanne (DP) einen vorgesehenen Kanalbereich (13) und einen für eine Driftstrecke (14, 15) vorgesehenen Bereich umfasst,
ein n-leitend dotierter Source-Bereich (2) in der tiefen p-leitend dotierten Wanne (DP) angeordnet wird,
ein Drain-Bereich (3) in der flachen n-leitend dotierten Wanne (SN) angeordnet wird,
ein Gate-Dielektrikum (7) über dem Kanalbereich (13) angeordnet wird und
eine Gate-Elektrode (5) auf dem Gate-Dielektrikum (7) angeordnet wird,
wobei zur Ausbildung einer Driftstrecke (14, 15) zwischen dem Kanalbereich (13) und dem Drain-Bereich (3) mit der Implantation der flachen n-leitend dotierten Wanne (SN) an der Oberseite des Halbleiterkörpers oder Substrates ein Gegendotierungsbereich (12) gebildet wird, der einen oberseitigen Bereich der tiefen p-leitend dotierten Wanne (DP, DP') überlappt und eine im Bereich der Driftstrecke (14, 15) angeordnete, drainseitige Grenzfläche aufweist, und in einem Abstand getrennt von der flachen n-leitend dotierten Wanne (SN) angeordnet ist.

4. Verfahren nach Anspruch 3, bei dem
eine flache p-leitend dotierte Wanne (SP) in der tiefen p-leitend dotierten Wanne (DP) auf der dem Source-Bereich (2) zugewandten Seite des Kanalbereiches (13) durch Implantation von Dotierstoff hergestellt wird und
der Source-Bereich (2) an die flache p-leitend dotierte Wanne (SP) angrenzend hergestellt wird.

5. Verfahren nach Anspruch 3 oder 4, bei dem
zwischen dem Kanalbereich (13) und dem Drain-Bereich (3) auf der Oberseite des Halbleiterkörpers oder Substrates ein Gate-Feldoxid (8) hergestellt wird und
die Implantation von Dotierstoff zur Ausbildung des Gegendotierungsbereiches (12) nach dem Herstellen des Gate-Feldoxids (8) erfolgt.

6. Verfahren nach Anspruch 5, bei dem
nach dem Herstellen der tiefen n-leitend dotierten Wanne (DN) und der tiefen p-leitend dotierten Wanne (DP) ein Gate-Feldoxid (8) hergestellt wird und
die flache n-leitend dotierte Wanne (SN) durch eine Implantation durch das Gate-Feldoxid (8) hindurch hergestellt wird.

## Claims

1. High-voltage NMOS transistor, in which
a deep n-conductively doped well (DN) and therein a deep p-conductively doped well (DP, DP') are formed in a semiconductor body or substrate (1) at a top side,
an n-conductively doped source region (2) is arranged in the deep p-conductively doped well (DP),
a channel region (13) adjoining the source region (2) and a gate electrode (5) above the channel region (13), said gate electrode being electrically insulated from the channel region, are present,
an n-conductively doped drain region (3) is arranged on a side of the channel region (13) opposite to the source region (2),
a drift path (14, 15) is present between the channel region (13) and the drain region (3),
a portion of the deep p-conductively doped well (DP, DP') is present along the drift path (14, 15),
a drain-side interface of the deep p-conductively doped well (DP, DP') is arranged in the region of the drift path (14, 15), and
a counterdoping region (12) doped with donors is present, which overlaps a region of the deep p-conductively doped well (DP, DP') that is present at the top side of the semiconductor body or substrate, and which forms at least one portion of the drift path (14),
**characterized in that**
a drain-side interface of the counterdoping region (12) is arranged in the region of the drift path (14, 15) and the drain region (3) is situated in a shallow n-conductively doped well (SN) arranged in the deep n-conductively doped well (DN) at a distance separately from the counterdoping region (12).

2. High-voltage NMOS transistor according to Claim 1, in which
a gate field oxide (8) having a maximum thickness of 0.5 µm is present over the drift path (14, 15).

3. Method for the production of a high-voltage NMOS transistor, in which
in a semiconductor body or substrate (1) at a top side by implantations of dopant, a deep n-conductively doped well (DN) is produced, a deep p-conductively doped well (DP) is produced and a shallow n-conductively doped well (SN) is produced, wherein
the deep p-conductively doped well (DP) is arranged in the deep n-conductively doped well (DN) such that a lower interface - present at a distance from the top side - of the deep p-conductively doped well (DP) is situated at a distance (A) above a lower interface of the deep n-conductively doped well, and a portion of the deep p-conductively doped well (DP) encompasses a channel region (13) provided and a region provided for a drift path (14, 15),
an n-conductively doped source region (2) is arranged in the deep p-conductively doped well (DP),
a drain region (3) is arranged in the shallow n-conductively doped well (SN),
a gate dielectric (7) is arranged over the channel region (13), and
a gate electrode (5) is arranged on the gate dielectric (7),
wherein in order to form a drift path (14, 15) between the channel region (13) and the drain region (3) with the implantation of the shallow n-conductively doped well (SN) at the top side of the semiconductor body or substrate, a counter doping region (12) is formed, which overlaps a top-side region of the deep p-conductively doped well (DP, DP') and has a drain-side interface arranged in the region of the drift path (14, 15) and is arranged at a distance separately from the shallow n-conductively doped well (SN).

4. Method according to Claim 3, in which
a shallow p-conductively doped well (SP) is produced in the deep p-conductively doped well (DP) on that side of the channel region (13) which faces the source region (2), by implantation of dopant, and
the source region (2) is produced in a manner adjoining the shallow p-conductively doped well (SP).

5. Method according to Claim 3 or 4, in which
a gate field oxide (8) is produced between the channel region (13) and the drain region (3) on the top side of the semiconductor body or substrate, and
the implantation of dopant for forming the counterdoping region (12) is effected after the production of the gate field oxide (8).

6. Method according to Claim 5, in which
a gate field oxide (8) is produced after the production of the deep n-conductively doped well (DN) and the deep p-conductively doped well (DP), and
the shallow n-conductively doped well (SN) is produced by an implantation through the gate field oxide (8).

## Revendications

1. Transistor NMOS de haute tension, dans lequel
il est formé, dans un corps semiconducteur ou un substrat (1) sur une face supérieure, une cuvette (DN) profonde dopée de conductivité n et dedans une cuvette (DP, DP') profonde dopée de conductivité p, une zone (2) de source dopée de conductivité n étant disposée dans la cuvette (DP) profonde dopée de conductivité p,
une zone (13) de canal voisine de la zone (2) de source et une électrode (5) de grille isolée électriquement de la zone de canal sont prévues au-dessus de la zone (13) de canal, une zone (3) de drain dopée de conductivité n est disposée d'un côté de la zone (13) de canal opposée à la zone (2) de source,
une section (14, 15) de migration est présente entre la zone (13) de canal et la zone (3) de drain,
une partie de la cuvette (DP, DP') profonde dopée de conductivité p est présente le long de la section (14, 15) de migration,
une interface côté drain de la cuvette (DP, DP') profonde dopée de conductivité p est disposée dans la zone de la section (14, 15) de migration, et
il y a une zone (12) de contre dopage dopée par des donneurs, qui chevauche une zone, prévue sur la face supérieure du corps semiconducteur ou du substrat (1), de la cuvette (DP, DP') profonde dopée de conductivité p et forme au moins une partie de la section (14) de migration,
**caractérisé en ce que**
une interface côté drain de la zone (12) de contre dopage est disposée dans la zone de la section (14, 15) de migration et la zone (3) de drain se trouve dans une cuvette (SN) plate dopée de conductivité n et disposée dans la cuvette (DN) profonde dopée de conductivité n en étant séparée à distance de la zone (12) de contre dopage.

2. Transistor NMOS de haute tension suivant la revendication 1, dans lequel un oxyde (6) de champ de grille ayant une épaisseur maximum de 0,5 µm est présent sur la section (14, 15) de migration.

3. Procédé de production d'un transistor NMOS de haute tension, dans lequel on produit, dans un corps semiconducteur ou un substrat (1) sur une face supérieure, par implantation de substances de dopage, une cuvette (DP) profonde dopée de conductivité n, une cuvette (DP) profonde dopée de conductivité p et une cuvette (SN) plate, dopée de conductivité n, dans lequel
on dispose la cuvette (DP) profonde dopée de conductivité p, dans la cuvette (DN) profonde dopée de conductivité n de façon à ce qu'une interface inférieure, prévue à distance de la face supérieure, de la cuvette (DP) profonde dopée de conductivité p, se trouve à une distance (A) au-dessus d'une interface inférieure de la cuvette profonde dopée de conductivité n et une partie de la cuvette (DP) profonde dopée de conductivité p entoure une zone (13) de canal prévue et une zone prévue pour une section (14, 15) de migration,
une zone (2) de source dopée de conductivité n est disposée dans la cuvette (DP) profonde dopée de conductivité p,
une zone (3) de drain est disposée dans la cuvette (SN) plate dopée de conductivité n,
un diélectrique (7) de grille est disposé au-dessus de la zone (13) de canal, et
une électrode (5) de grille est disposée sur le diélectrique (7) de grille,
dans lequel, pour former une section (14, 15) de migration entre la zone (13) de canal et la zone (3) de drain par l'implantation de la cuvette (SN) plate dopée de conductivité n, on forme sur la face supérieure du corps semiconducteur ou du substrat une zone (12) de contre dopage, qui chevauche une zone du côté supérieur de la cuvette (DP, DP') profonde de conductivité p et a une interface côté drain disposée dans la zone de la section (14, 15) de migration et est disposée séparée à distance de la cuvette (SN) plate dopée de conductivité n.

4. Procédé suivant la revendication 3, dans lequel
on produit une cuvette (SP) plate dopée de conductivité p dans la cuvette (DP) profonde dopée de conductivité p du côté, tourné vers la zone (2) de source, de la zone (13) de canal par implantation de substance de dopage, et
on produit la zone (2) de source au voisinage de la cuvette (SP) plate dopée de conductivité p.

5. Procédé suivant la revendication 3 ou 4, dans lequel
on produit un oxyde (8) de champ de grille entre la zone (13) de canal et la zone (3) de drain sur la face supérieure du corps semiconducteur ou du substrat, et
on effectue l'implantation de substance de dopage pour former la zone (12) de contre dopage après la production de l'oxyde (8) de champ de grille.

6. Procédé suivant la revendication 5, dans lequel
après la production de la cuvette (DN) profonde dopée de conductivité n et de la cuvette (DP) profonde dopée de conductivité p, on produit un oxyde (8) de champ de grille, et
on produit la cuvette (SN) plate dopée de conductivité n en effectuant une implantation à travers l'oxyde (8) de champ de grille.
